# EUROPEAN PATENT APPLICATION

(11) **EP 1 330 032 A1**
(43) Date of publication of application: **23.07.2003**
(21) Application number: 02075260.6
(22) Date of filing: 22.01.2002
(51) Int. Cl.: H03K 4/69

(54) **Driving a field deflection coil of a display apparatus**

(71) Applicant: Koninklijke Philips Electronics N.V., 5621 BA Eindhoven (NL)
(72) Inventor: Nieland, Jan-Harm c/o Internationaal Octrooibureau, 5656 AA Eindhoven (NL)
(74) Representative: Steenbeek, Leonardus Johannes

(57) **Abstract**

A field deflection amplifier circuit comprises a class D output stage which has an output to supply a field deflection current (Idefl) to a field deflection coil (Ldefl) via a low pass filter (Of), a flyback power supply voltage (Vflb) is supplied to the output (N3) of the class D amplifier or to the junction (N5) of the field deflection coil (Ldefl) and the low pass filter (Of).

## Description

### Field of the invention

The invention relates to a field deflection amplifier circuit, a field deflection circuit comprising such a field deflection amplifier circuit, and a display apparatus comprising such a field deflection circuit.

In particular the display apparatus may be a television receiver or a computer monitor.

### Background of the invention

EP-A-1022855 discloses a class D vertical deflection amplifier. A series arrangement of main current paths of a first and a second MOSFET transistor provide a class D output stage. The vertical deflection coil is connected to the junction of main electrodes of the first and the second MOSFET via a low pass filter. The free main electrode of the first MOSFET is connected to a first node. A main current path of a third MOSFET is connected between the scan power supply voltage source and the first node. A fourth MOSFET has a main current path connected between a flyback power supply voltage source and the first node.

During the scan period of the vertical period, the third MOSFET is conductive to supply the scan power supply voltage to the class D output stage, and the fourth MOSFET is non-conductive to prevent the flyback power supply voltage to be applied to the class D output stage. During the relatively short flyback period of the vertical period, the third MOSFET is non-conductive and the fourth MOSFET is conductive to present the relatively high flyback power supply voltage to the class D output stage.

The first node is a power supply input of the class D output stage which receives either the scan power supply voltage Vp or the flyback power supply voltage Vflb. The scan power supply voltage Vp has a value optimally fitting the voltage requirements during the scan period Tsc, the relatively high flyback voltage Vflb allows a quick flyback during the relatively short flyback period Tfl.

Although class D amplifiers with a separate scan power supply voltage Vp and flyback power supply voltage have a high efficiency with respect to class A/B amplifiers, it is a drawback of the known class D vertical deflection amplifier that the efficiency is not optimal.

### Summary of the invention

It is an object of the invention to provide a class D field deflection amplifier with an improved efficiency.

A first aspect of the invention provides a field deflection amplifier circuit as claimed in claim 1. A second aspect of the invention provides a field deflection circuit comprising such a field deflection amplifier circuit as claimed in claim 8. A third aspect of the invention provides a display apparatus comprising such a field deflection circuit as claimed in claim 9. Advantageous embodiments are defined in the dependent claims.

The claimed invention is based on the insight that, at least during part of the flyback period, the flyback current in the deflection coil flows through prior art's flyback MOSFET transistor (the fourth transistor in the claims) and one of the transistors of the class D output stage (the first transistor in the claims).

If the flyback transistor is coupled to the output of the class D output stage which usually is the junction of the two series arranged transistors (the first and the second transistor in the claims) of the class D output stage, the flyback current will only flow through the flyback transistor, and the dissipation in the first transistor will not occur. Consequently, at a same value of the flyback power supply voltage, the dissipation in the class D field deflection amplifier will be lower. Further, due to the omission of the voltage drop across the first transistor, the flyback voltage across the field deflection coil will be larger and the flyback time shorter.

In the claims, the prior art's vertical deflection is replaced by field deflection to indicate that a class D field deflection amplifier applied in a transposed scan display apparatus is within the scope of the claims. In a usual display apparatus, the line deflection circuit scans lines in the horizontal direction and the field deflection circuit scans in the vertical direction such that horizontal lines succeed each other in the vertical direction. In transposed scan display apparatus, the line deflection circuit scans vertical lines which are scanned in the horizontal direction by the field deflection circuit.

In an embodiment in accordance with the invention as defined in claim 3, the flyback transistor is connected to the junction of the first and the second transistor. In this way, the flyback power supply voltage is supplied to the series arrangement of the low pass filter and the field deflection coil.

In an embodiment in accordance with the invention as defined in claim 4, the flyback transistor is connected to the junction of the low pass filter and the field deflection coil. Now, the flyback current need not flow through the low pass filter which allows a shorter flyback period or which allows a lower flyback power supply voltage.

These and other aspects of the invention are apparent from and will be elucidated with reference to the embodiments described hereinafter.

### Brief description of the drawings

In the drawings:
Fig. 1 shows a basic block diagram of a known class D amplifier,
Figs. 2A and 2B show waveforms for elucidating the operation of the known class D amplifier,
Fig. 3 shows a first embodiment of a field deflection circuit in accordance with the invention,
Fig. 4 shows a second embodiment of a field deflection circuit in accordance with the invention,
Fig. 5 shows waveforms elucidating the operation of the field deflection circuit,
Fig. 6 shows a detail of the waveforms of Fig. 3,
Fig. 7 shows a third embodiment of a field deflection circuit in accordance with the invention, and
Fig. 8 shows a display apparatus with a field deflection circuit in accordance with the invention.

### Detailed description of the preferred embodiments

In the Figures, the same references indicate items having the same function.

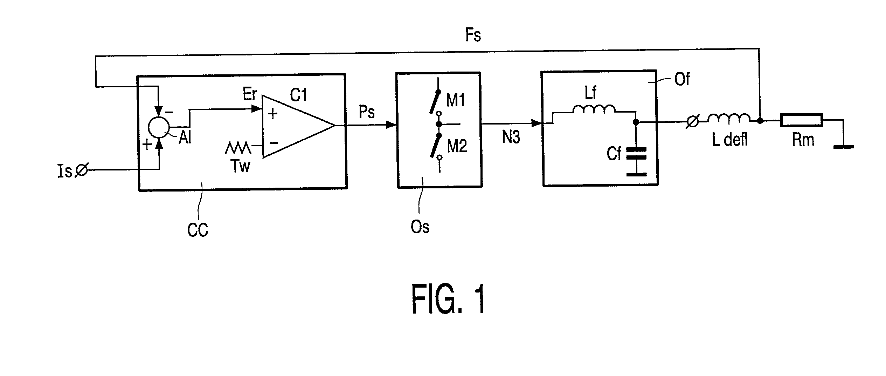

Fig. 1 shows a basic block diagram of a known class D amplifier. This class D amplifier comprises a controller or pulse width modulator CC, an output amplifier Os and a filter Of.

An analog input signal Is is converted by the pulse width modulator CC into a pulse width signal Ps which is filtered by the filter Of connected to the output N3 of the output amplifier Os before it is supplied to the deflection coil Ldefl.

The pulse width modulator CC comprises a differential amplifier A1, and a comparator C1. The amplifier A1 has a non-inverting input which receives the input signal Is, an inverting input which receives a feedback signal Fs, and an output which supplies a difference signal Er. The comparator C1 has a non-inverting input which receives the difference signal Er, an inverting input which receives a sloping waveform Tw, and an output which supplies the pulse width signal Ps.

The class D output stage Os comprises a series arrangement of a first transistor M1 and a second transistor M2. The on and off periods of the transistors M1 and M2 are controlled in response to the pulse width signal Ps. The junction of the transistors M1 and M2 is the output node N3 of the class D output stage Os.

The low pass filter Of preferably comprises an inductor Lf arranged between the output node N3 and the deflection coil Ldefl, and a capacitor Cf arranged between a junction of the inductor Lf and the deflection coil Ldefl and ground.

A feedback resistor Rm connects the deflection coil Ldefl to ground. A feedback signal Fs is available at the junction of the deflection coil Ldefl and the feedback resistor Rm.

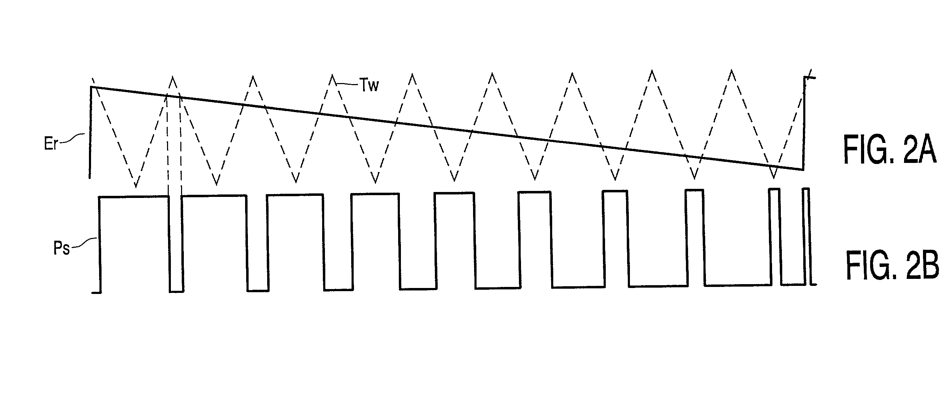

The operation of the known class D amplifier is elucidated in the now following. The differential amplifier A1 compares the input signal Is with a the feedback signal Fs to supply an error signal Er. The error signal is compared with the sloping waveform Tw which may be a sawtooth or a triangle waveform Tw as shown in Fig. 2. The pulse width signal Ps switches level at the instants the triangle waveform Tw crosses the error signal Er.

Figs. 2A and 2B show waveforms for elucidating the operation of the known class D amplifier of Fig. 1. Fig. 2A shows the triangle waveform Tw and the error signal Er as a field frequent sawtooth signal. In Fig. 2A, the frequency of the triangle waveform Tw is selected to allow a good elucidation of the principle, in practice this frequency will be much higher. Fig. 2B shows that the pulse width signal Ps has a high level if the error signal Er has a level higher than the level of the triangle waveform Tw, and a low level if the error signal Er has a level below the level of the triangle waveform Tw. As is clear from Fig. 2B, the duty cycle of the pulse width signal Ps decreases within the field period.

The pulse width signal Ps is in a known way converted into drive signals of the first transistor M1 and the second transistor M2 which have opposite polarities. The ratio between the on-time of the first transistor M1 and the second transistor M2 determines the voltage across the deflection coil Ldefl in a known way: if the ratio is large, the voltage is high, and the other way around.

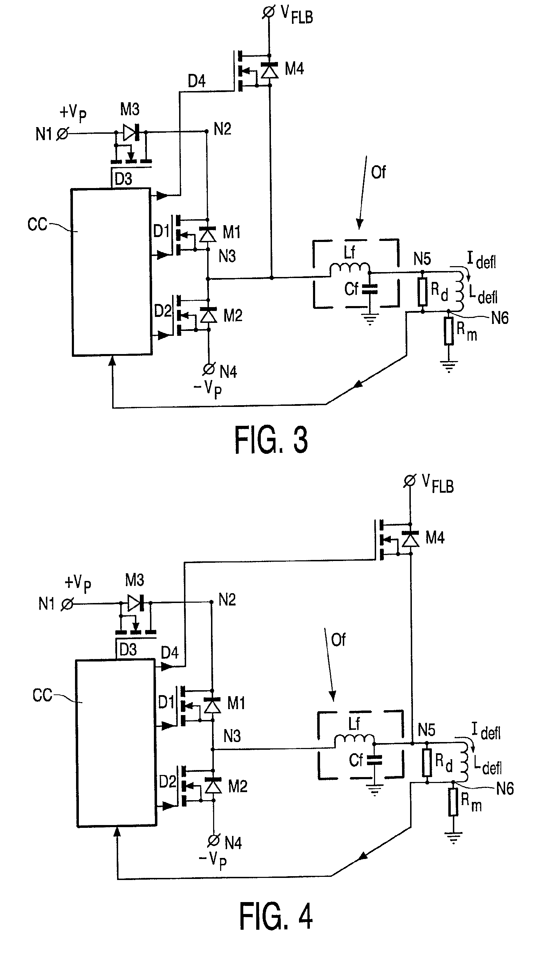

Fig. 3 shows a first embodiment of a field deflection circuit in accordance with the invention.

The field deflection circuit comprises a class D output stage which has a first MOSFET transistor M1 and a second MOSFET transistor M2. The transistor M1 has a control input (the gate) coupled to the control circuit CC to receive a control signal D1, and a main current path arranged between nodes N2 and N3: the drain is coupled to the node N2 and the source is coupled to the node N3. The body diode of the transistor M1 has a cathode coupled to the node N2 and an anode coupled to the node N3. The transistor M2 has a gate coupled to the control circuit CC to receive a control signal D2, a drain which is coupled to the node N3, a source which is coupled to the node N4, and a body diode which has a cathode coupled to the node N3 and an anode coupled to the node N4.

The transistor M3 has a gate coupled to the control circuit CC to receive a control signal D3, a drain which is coupled to the node N2, a source which is coupled to the node N1, and a body diode which has a cathode coupled to the node N2 and an anode coupled to the node N1.

The transistor M4 has a gate coupled to the control circuit CC to receive a control signal D4, a drain which is coupled to a flyback power supply voltage source, a source which is coupled to the node N3, and a body diode which has a cathode coupled to the flyback power supply voltage source and an anode coupled to the node N3.

An output filter Of is coupled between the nodes N3 and N5. The output filter Of preferably comprises an inductance Lf arranged between the nodes N3 and N5 and a capacitor Cf arranged between node N5 and ground.

The deflection coil Ldefl is arranged between the nodes N5 and N6. Usually, a resistor Rd is arranged in parallel with the deflection coil Ldefl.

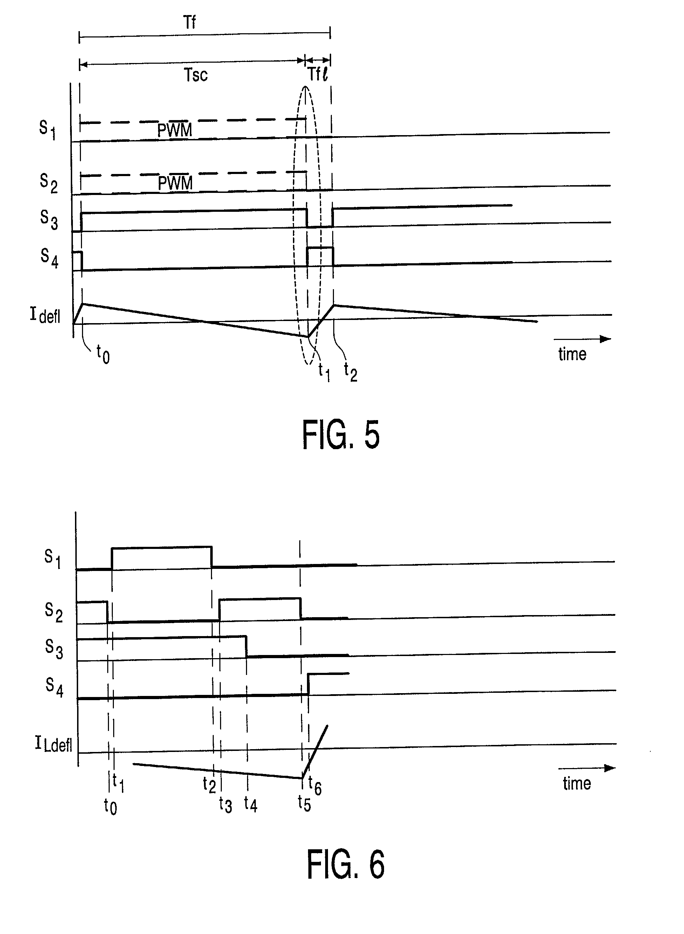

A feedback resistor Rm is arranged between the node N6 and ground. A feedback voltage across the feedback resistor Rm is supplied to the control circuit CC which controls the switches M1 to M4 in a known way. A scan power supply voltage source is coupled between the nodes N1 and N4, the positive polarity is supplied to node N1. The operation of the field deflection circuit will become clear from the elucidation given with respect to Figs. 5 and 6.

Fig. 4 shows a second embodiment of a field deflection circuit in accordance with the invention. The same references refer to the same items as in Fig. 3. The only difference with Fig. 3 is that the source of the transistor M4 is now connected to the node N5 instead to the node N3.

Fig. 5 shows waveforms elucidating the operation of the field deflection circuit. The waveforms S1, S2, S3, S4 represent the state of switch M1, M2, M3, M4, respectively. Idefl depicts the current through the deflection coil Ldefl. At the instant t0, a scan period Tsc of a field period Tf starts: the transistor M3 becomes conductive and the transistor M4 becomes non-conductive. Consequently, the power supply voltage of the class D amplifier stage becomes the scan power supply voltage Vp. The transistors M1 and M2 are switched on and off with a frequency which is relatively high with respect to the field frequency which is the reciprocal of the field period Tf. As it is not illustrative to show the high frequency switching in the field period Tf this is indicated in Fig. 5 by dotted lines above and below the abbreviation PWM (Pulse Width Modulation). In Fig. 6 the period of time around the instant t1 at which the scan period Tsc ends and the flyback period Tfb starts is magnified, allowing to explicitly show the on and off times of the transistors M1 and M2.

During the scan period Tsc, the control circuit CC controls the on and off times of the transistors M1 and M2 in a known manner in response to the feedback voltage across the feedback resistor Rm to obtain the substantial linear deflection current Idefl.

During the flyback period, the transistors M1, M2 and M3 are non-conductive and the transistor M4 is conductive. The high flyback power supply voltage Vflb is supplied to the node N3 (Fig. 3) or the node N5 (Fig. 4) and consequently, the current through the deflection coil Ldefl will change its polarity within the short flyback period Tfl.

At the instant t2 a next scan period Tsc starts.

Fig. 6 shows a detail of the waveforms of Fig. 5. The instant t5 corresponds to the instant t1 in Fig. 5 where the scan period Tsc ends and the flyback period Tfl starts.

Again, the waveforms S1, S2, S3, S4 represent the state of switch M1, M2, M3, M4, respectively. Idefl depicts the current Idefl through the deflection coil Ldefl.

The transistor M1 is conductive from the instant t1 to the instant t2. The transistor M2 is conductive from the instant t3 to the instant t5. The periods of conductance of the transistors M1 and M2 are disjunct (the transistor M2 is off from the instant t0 to the instant t3) to prevent a large shortcut current through these transistors M1 and M2.

Although with respect to Fig. 5 it was elucidated that the transistor M3 should be conductive during the scan period Tsc, this is only absolutely necessary during the periods that the transistor M2 is not conductive. As long as the transistor M2 is conductive, the deflection current Idefl will flow through this transistor and consequently the state of the transistors M1 and M3 is not important. However, it is important that the transistor M3 is conductive when the current through the transistor M2 flows from its drain to its source, the transistor M2 is about to stop conducting, and the flyback period should not yet start.

At the instant t5 which is the end of the scan period Tsc, the transistor M3 should first be controlled to become non-conductive before the transistor M4 is controlled to become conductive to prevent a large shortcut current flowing through the series arrangement of the transistors M3 and M4. Therefore, at the instant t4, during the period that the transistor M2 is conductive, the transistor M3 is switched off.

To prevent a large current through the series arrangement of the transistors M4 and M2, the transistor M4 should be switched on at an instant t6 not earlier than the transistor M2 has been switched off at the instant t5. Just before the instant t5, the deflection current Idefl flows through the conducting transistor M2. At the instant t5, all the switches M1 to M4 are non-conductive. The deflection current Idefl causes a high voltage at the node N3 and the deflection current Idefl changes the sign of its derivative to time. At the instant t6, the flyback power supply voltage Vflb is supplied to the deflection coil Ldefl via the switch M4.

After a certain amount of time, at instant t2, the deflection current Idefl reaches the value it should have at the start of the scan. At that moment switch M4 can be turned off. The deflection current Idefl will flow through the body diode of M2, switch M3 can be turned on again and at the same moment the control circuit CC can start operating the switches M1 and M2 in the PWM mode.

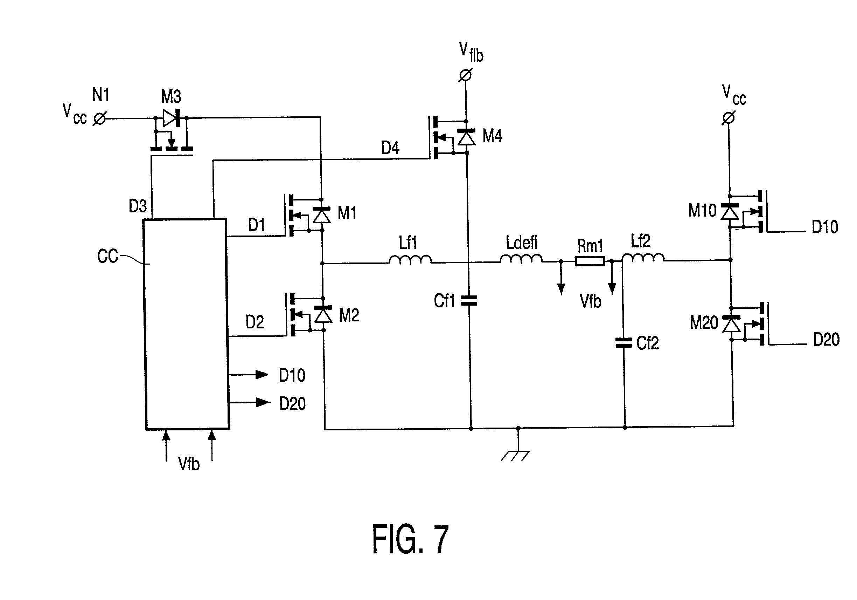

Fig. 7 shows a third embodiment of a field deflection circuit in accordance with the invention. This figure shows a full bridge field deflection circuit. The same references refer to the same items as in Fig. 3. The transistors M1, M2 with their intrinsic body diodes form a first class D output stage which operates in a well known way. The transistors M10, M20 and their intrinsic body diodes form a second class D output stage. Both class D output stages are constructed, and operate in a well known manner. A series arrangement of a first filter comprising the inductor Lf1 and the capacitor Cf1, the deflection coil Ldefl, the feedback resistor Rml, and a second filter comprising the inductor Lf2 and the capacitor Cf2, is arranged between the outputs of the first and the second class D output stage. The transistor M4 is connected to the junction of the first filter comprising the inductor Lf1 and the capacitor Cf1, and the deflection coil Ldefl. Alternatively, the transistor M4 may be connected to the output of one of the class D outputs stages, or to the other one of the terminals of the deflection coil Ldefl. The full bridge field deflection circuit operates in a well known manner, however, the flyback voltage is provided in a more energy efficient way.

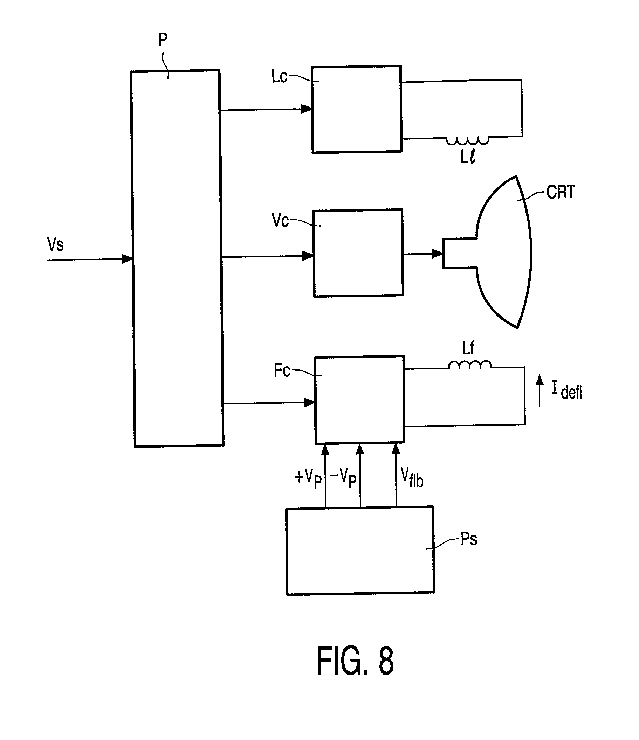

Fig. 8 shows a display apparatus with a field deflection circuit in accordance with the invention. A processing circuit P receives an input signal Vs comprising synchronization and video information. The input signal may be a composite signal, for example CVBS, or may comprise separate signals, for example, RGB signals, a line synchronization signal and a field synchronization signal. The processing circuit P supplies the line synchronization signal to a line deflection circuit Lc which drives a line deflection coil L1, the video information to a video processing circuit Vc which drives electrodes of the cathode ray tube CRT, and the field synchronization signal to the field deflection circuit Fc which drives the field deflection coil Lf. A power supply Ps provides a positive scan power supply voltage +Vp, a negative scan power supply voltage -Vp and the flyback power supply voltage Vflb to the field deflection circuit Fc, and power supply voltages to the other circuits (not shown).

It should be noted that the above-mentioned embodiments illustrate rather than limit the invention, and that those skilled in the art will be able to design many alternative embodiments without departing from the scope of the appended claims.

For example, the flyback power supply voltage may be generated with the use of a capacitor as known from EP-A-1022855. The power supply Ps does not need to supply a separate flyback power supply voltage Vflb in this situation. It is also possible to use MOSFETs or other electronic switches without internal body diodes or with diodes which are not arranged between the source and the drain, but separate diodes are required now. The body diodes of the MOSFETs may be external diodes if faster diodes or diodes with a lower forward voltage are required. Instead of the MOSFETs, it is also possible to use DMOST transistors with or without its body diodes.

The deflection coil Ldefl may comprise a series and/or parallel arrangement of several coils.

In the claims, any reference signs placed between parentheses shall not be construed as limiting the claim. The word "comprising" does not exclude the presence of other elements or steps than those listed in a claim. The invention can be implemented by means of hardware comprising several distinct elements, and by means of a suitably programmed computer. In the device claim enumerating several means, several of these means can be embodied by one and the same item of hardware.

## Claims

1. A field deflection amplifier circuit for supplying a field deflection current (Idefl) being periodic with a field period (Tf), comprising a scan period (Tsc) and a flyback period (Tfl), the field deflection amplifier circuit comprising:
a class D amplifier output stage (M1, M2) having an output (N3) for supplying the field deflection current (Idefl),
a first switching means (M3) for coupling a scan power supply voltage (+Vp) to the class D amplifier output stage in the scan period (Tsc), and
a second switching means (M4) for coupling a flyback power supply voltage (Vflb) to said output (N3) in the flyback period (Tflb).

2. A field deflection amplifier circuit as claimed in claim 1, **characterized in that**
the class D amplifier output stage comprising a series arrangement of a first transistor (M1) and a second transistor (M2),
the first switching means (M3) comprises a third transistor (M3) for coupling a scan power supply voltage (+Vp) to the series arrangement of a first transistor (M1) and a second transistor (M2), and
the second switching means (M4) comprises a fourth transistor (M4) for coupling the flyback power supply voltage (Vflb) to a junction (N3) of the first transistor (M1) and the second transistor (M2).

3. A field deflection amplifier circuit as claimed in claim 2, **characterized in that** the amplifier circuit further comprises a low pass filter (Of) coupled between the junction (N3) and the field deflection coil (Ldefl) wherein the fourth transistor (M4) is connected to the junction (N3).

4. A field deflection amplifier circuit as claimed in claim 2, **characterized in that** the amplifier circuit further comprises a low pass filter (Of) coupled between the junction (N3) and the field deflection coil (Ldefl) wherein the fourth transistor (M4) is connected to a junction (N5) of the low pass filter (Of) and the field deflection coil (Ldefl).

5. A field deflection amplifier circuit as claimed in claim 2, **characterized in that** the field deflection amplifier circuit further comprises a control circuit (CC) for controlling:
i) during the scan period (Ts), the first transistor (M1) and second transistor (M2) as the class D amplifier output stage, the third transistor (M3) to be conductive to supply the scan power supply voltage (+Vp) to the class D amplifier output stage (M1, M2), and the fourth transistor (M4) to be non-conductive to prevent coupling of the flyback power supply voltage (Vflb) to the field deflection coil (Ldefl), and
ii) during the flyback period (Tfl), the first transistor (M1), the second transistor (M2) and third transistor (M3) to be non-conductive, and the fourth transistor (M4) to be conductive to provide the flyback power supply voltage (Vflb) to the field deflection coil (Ldefl).

6. A field deflection amplifier circuit as claimed in claim 1, **characterized in that** the field deflection amplifier circuit comprises a further class D amplifier output stage (M10, M20) comprising a further output, the first mentioned class D amplifier output stage (M1, M2) and the further class D amplifier output stage (M10, M20) being arranged to obtain a full bridge amplifier wherein, in operation, the deflection current (Idefl) flows between the first mentioned output and the further output.

7. A field deflection amplifier circuit as claimed in claim 2, **characterized in that** the first transistor (M1) comprises a MOSFET with an intrinsic body diode having an anode coupled to the junction (N3) of the first transistor (M1) and the second transistor (M2), and the third transistor (M3) comprises a MOSFET with an intrinsic body diode having an cathode coupled to a junction (N2) of the first transistor (M1) and the third transistor (M3).

8. A field deflection circuit comprising:
a field deflection coil (Ldefl),
a field deflection amplifier circuit for supplying a field deflection current (Idefl) being periodic with a field period (Tf) comprising a scan period (Tsc) and a flyback period (Tfl) to the field deflection coil (Ldefl), the field deflection amplifier circuit comprising:
a class D amplifier output stage (M1, M2) having an output (N3) for supplying the field deflection current (Idefl),
a first switching means (M3) for coupling a scan power supply voltage (+Vp) to the class D amplifier output stage during the scan period (Tsc), and
a second switching means (M4) for coupling a flyback power supply voltage (Vflb) to the output (N3) during the flyback period (Tflb).

9. A display apparatus comprising:
a cathode ray tube (CRT),
a field deflection coil (Ldefl) magnetically coupled to the cathode ray tube (CRT) to deflect an electron beam in the cathode ray tube (CRT),
a field deflection amplifier circuit for supplying a field deflection current (Idefl) being periodic with a field period (Tf) comprising a scan period (Tsc) and a flyback period (Tfl) to the field deflection coil (Ldefl), the field deflection amplifier circuit comprising:
a class D amplifier output stage (M1, M2) having an output (N3) for supplying the field deflection current (Idefl),
a first switching means (M3) for coupling a scan power supply voltage (+Vp) to the class D amplifier output stage during the scan period (Tsc), and
a second switching means (M4) for coupling a flyback power supply voltage (Vflb) to the output (N3) during the flyback period (Tflb).
